# EUROPEAN PATENT APPLICATION

(11) **EP 4 047 567 A1**
(43) Date of publication of application: **24.08.2022**
(21) Application number: 22157190.4
(22) Date of filing: 17.02.2022
(51) Int. Cl.: G06V 40/13, G06K 19/07, G06K 19/077, H01L 23/31, H05K 3/28

(54) **SMART CARD FOR RECOGNIZING FINGERPRINT**

(30) Priority: 19.02.2021 TW 110201862 U
(71) Applicant: IDSpire Corporation Ltd., 22041 New Taipei City (TW)
(72) Inventor: SU, Yu-Sung, 22041 New Taipei City (TW)
(74) Representative: Marks & Clerk LLP

(57) **Abstract**

A smart card includes a card body (1), a transmission unit (2), a fingerprint sensor (3), a processing unit (4) and a cover layer (5). The card body (1) is formed with a cavity (13). The transmission unit (2) is disposed on the card body (1), and outputs electricity. The fingerprint sensor (3) is connected to the transmission unit (2), is accommodated in the cavity (13), and generates a detection signal after receiving the electricity. The processing unit (4) is disposed in the card body (1), is connected to the transmission unit (2) and the fingerprint sensor (3), and performs signal processing on the detection signal after receiving the electricity. The cover layer (5) is disposed in the cavity (13) and covers the fingerprint sensor (3) .

## Description

The disclosure relates to a smart card, and more particularly to a smart card for recognizing a fingerprint of a user.

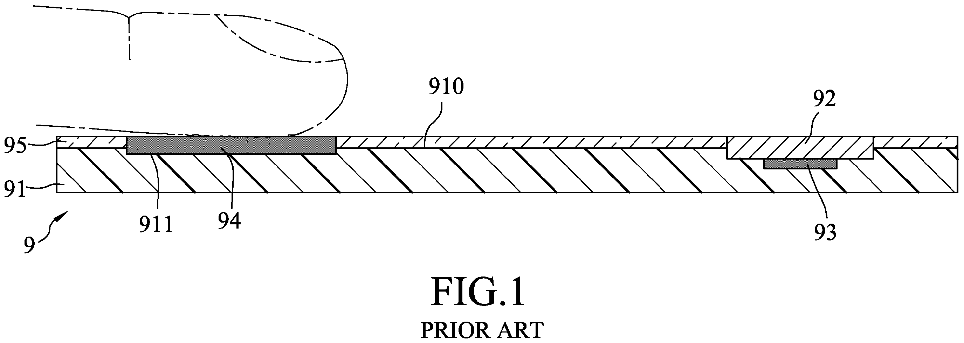

Referring to Figure 1, a conventional smart card includes a card body 91, a protective layer 95, a processing unit 93, a fingerprint sensor 94 that is electrically connected to the processing unit 93, and a transmission unit 92 that is electrically connected to the processing unit 93 and the fingerprint sensor 94. The card body 91 is formed with a cavity 911 in a front surface 910 thereof. The transmission unit 92 is disposed on the front surface 910 of the card body 91, and is configured to output electricity to the processing unit 93 and the fingerprint sensor 94 upon receiving an electrical signal from a card reader (not shown) when the card reader is coupled to the transmission unit 92. The fingerprint sensor 94 is accommodated in the cavity 911, and is configured to detect a fingerprint and to generate a detection signal based on detection of the fingerprint. The processing unit 93 is disposed in the card body 91, and performs signal processing on the detection signal. The protective layer 95 is disposed on the front surface 910 of the card body 91, and the transmission unit 92 and the fingerprint sensor 94 are exposed from and coplanar with the protective layer 95.

Since the fingerprint sensor 94 is not covered by anything, the fingerprint sensor 94 is prone to being stained with dust, which would reduce sensitivity of fingerprint detection and accuracy of fingerprint identification.

Therefore, an object of the disclosure is to provide a smart card for recognizing a fingerprint of a user that can alleviate at least one of the drawbacks of the prior art.

According to the disclosure, the smart card includes a card body, a transmission unit, a fingerprint sensor, a processing unit and a cover layer.

The card body has a front surface and a back surface that are opposite to each other, and is formed with a cavity on the front surface.

The transmission unit is disposed on the card body, and is configured to be coupled to a card reading module, and to output electricity based on an electrical signal generated by the card reading module.

The fingerprint sensor is electrically connected to the transmission unit for receiving the electricity therefrom, has a sensing surface for detecting the fingerprint, is accommodated in the cavity of the card body with the sensing surface opposite to the back surface of the card body and receding with respect to the front surface, and is configured to be activated in response to receipt of the electricity from the transmission unit, and after being activated, to generate a detection signal based on the fingerprint upon detecting the fingerprint.

The processing unit is disposed in the card body, is electrically connected to the transmission unit and the fingerprint sensor respectively for receiving the electricity and the detection signal therefrom, and is configured to be activated in response to receipt of the electricity from the transmission unit and after being activated, to perform signal processing on the detection signal upon receiving the detection signal.

The cover layer is disposed in the cavity of the card body and covers the sensing surface of the fingerprint sensor.

Other features and advantages of the disclosure will become apparent in the following detailed description of the embodiments with reference to the accompanying drawings, of which:
Figure 1 is a schematic diagram illustrating a sectional view of a conventional smart card;
Figure 2 is a top view of a smart card according to a first embodiment of the disclosure;
Figure 3 is a sectional view of the smart card taken along a sectional line III-III in Figure 2 according to the first embodiment of the disclosure;
Figure 4 is a block diagram illustrating an example of the smart card according to the first embodiment of the disclosure; and
Figure 5 is a schematic diagram illustrating an example of a sectional view of the smart card according to a second embodiment of the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

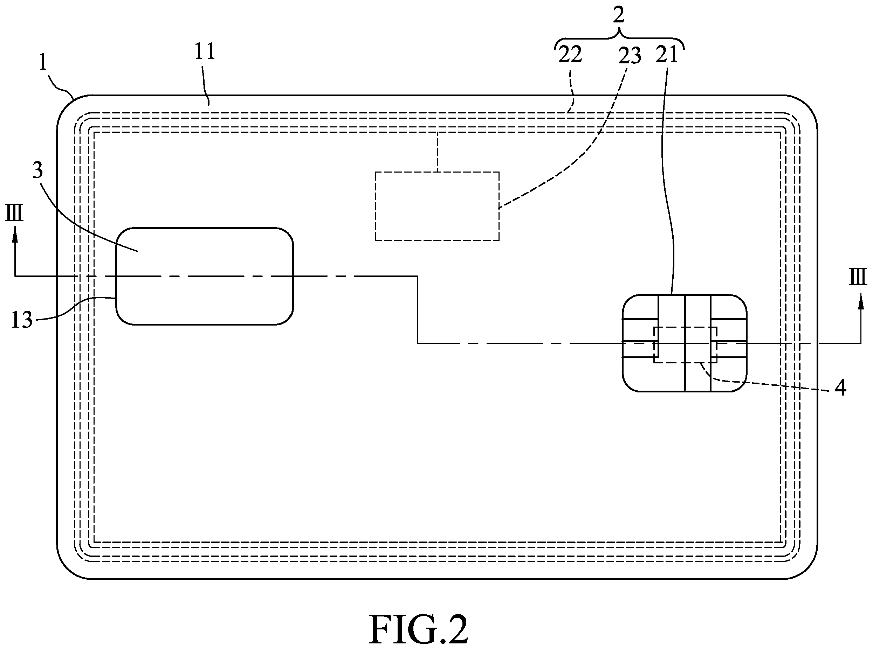

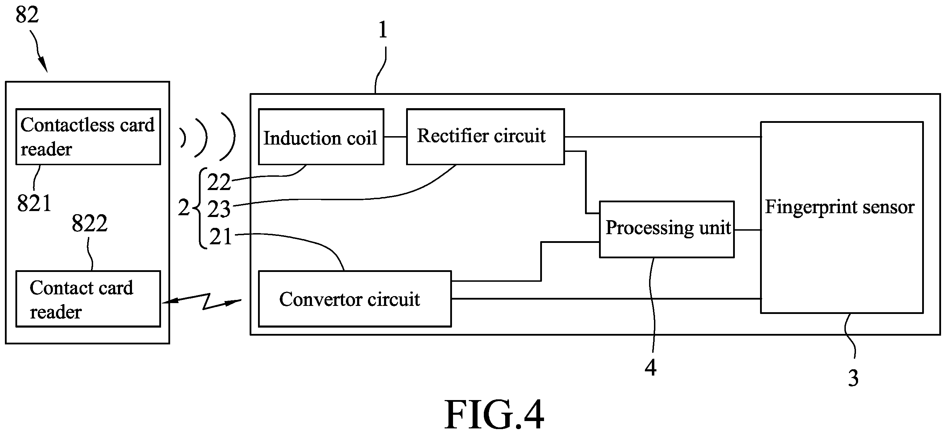

Referring to Figures 2 to 4, a first embodiment of a smart card for recognizing a fingerprint 81 of a user according to the disclosure is illustrated. The smart card is adapted to be connected to a card reading module 82.

The card reading module 82 is adapted to be coupled to a computer or a cloud computing platform (e.g., a cloud server) for accessing a database running thereon. The card reading module 82 includes a contactless card reader 821 and a contact card reader 822. The contactless card reader 821 and the contact card reader 822 are accommodated in a housing (not shown) of the card reading module 82.

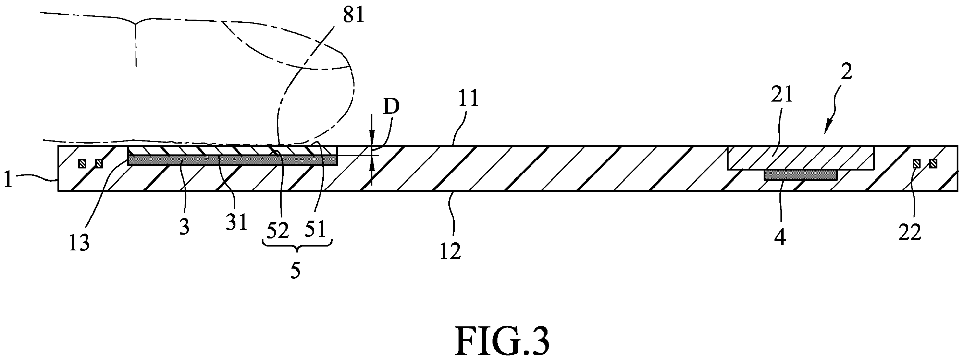

The smart card includes a card body 1, a transmission unit 2, a fingerprint sensor 3, a processing unit 4 and a cover layer 5. It should be noted that an actual overall thickness of the smart card is relatively thin, and for clarity of illustration, components of the smart card may be enlarged where appropriate in Figure 3; that is to say, Figure 3 is only a schematic view and does not illustrate the components of the smart card to scale.

The card body 1 has an appearance of a rectangular sheet, and is made of plastic. The card body 1 has a front surface 11 and a back surface 12 that are opposite to each other, and is formed with a cavity 13 in the front surface 11. In one embodiment, the card body 1 is made of other electrical insulator such as silicone rubber and polyimide, and has a specific appearance that is designed based on needs.

The transmission unit 2 is disposed on the card body 1. The transmission unit 2 is configured to be coupled to the card reading module 82, and to output electricity based on an electrical signal generated by the card reading module 82.

Specifically, the transmission unit 2 includes an induction coil 22 and a rectifier circuit 23. The induction coil 22 is embedded in the card body 1. The induction coil 22 serves as an antenna for communicating with the contactless card reader 821, and is configured to be inductively coupled to the contactless card reader 821 so as to induce generation of the electrical signal by the contactless card reader 821 to thereby produce an alternating current (AC) voltage through electromagnetic induction. The rectifier circuit 23 is electrically connected between the induction coil 22 and each of the fingerprint sensor 3 and the processing unit 4. The rectifier circuit 23 is configured to generate the electricity in direct current (DC) based on the AC voltage produced by the induction coil 22, and to provide the electricity to the fingerprint sensor 3 and the processing unit 4.

The transmission unit 2 further includes a convertor circuit 21. The convertor circuit 21 is electrically connected to the fingerprint sensor 3 and the processing unit 4, and is disposed on and exposed from the front surface 11 of the card body 1. The convertor circuit 21 is configured to be physically and electrically connected to the contact card reader 822 for receiving the electrical signal from the contact card reader 822 and to convert the electrical signal into the electricity. In some embodiments, the converter circuit 21 may be implemented to have a contact pad (see Figure 2) for receiving the electrical signal from the contact card reader 822, and a rectification circuit (not shown) for converting the electrical signal into the electricity in DC; in other embodiments, the transmission unit 2 does not include the converter circuit 21, and the transmission unit 2 includes the contact pad that is electrically connected to the rectifier circuit 23 for transmitting the electrical signal to the rectifier circuit 23, which then generates the electricity based on the electrical signal.

In one embodiment, the induction coil 22 and the rectifier circuit 23 of the transmission unit 2 are omitted, so the transmission unit 2, which includes the converter circuit 21, is only allowed to be connected to the contact card reader 822.

In one embodiment, the convertor circuit 21 of the transmission unit 2 is omitted, so the transmission unit 2, which includes the induction coil 22 and the rectifier circuit 23, is only allowed to be used with the contactless card reader 821.

The fingerprint sensor 3 is electrically connected to the transmission unit 2 for receiving the electricity therefrom, and is configured to operate based on the electricity. The fingerprint sensor 3 has a sensing surface 31 for detecting the fingerprint 81, and is accommodated in the cavity 13 of the card body 1 with the sensing surface 31 opposite to and faces away from the back surface 12 of the card body 1 and receding with respect to the front surface 11. The fingerprint sensor 3 is configured to be activated in response to receipt of the electricity from the transmission unit 2, and after being activated, to generate a detection signal based on the fingerprint 81 upon detecting the fingerprint 81.

The fingerprint sensor 3 includes a contact pad and a controller (not shown), and the whole of the fingerprint sensor 3 is implemented by an unpackaged chip. The controller of the fingerprint sensor 3 includes a substrate that may be implemented by a silicon substrate, a glass substrate, a polyimide (PI) film, an Ajinomoto build-up film (ABF), bismaleimide triazine resin film, or the like.

The processing unit 4 is disposed in the card body 1 under the transmission unit 2, and is closer to the back surface 12 of the card body 1 than the transmission unit 2. The processing unit 4 is electrically connected to the transmission unit 2 (specifically, the convertor circuit 21 and the rectifier circuit 23) and the fingerprint sensor 3 respectively for receiving the electricity and the detection signal therefrom. The processing unit 4 is configured to be activated in response to receipt of the electricity from the transmission unit 2, and after being activated, to perform signal processing on the detection signal upon receiving the detection signal.

In one embodiment, the processing unit 4 is configured to store in advance reference data that indicates a reference fingerprint of a holder of the smart card, and to perform fingerprint comparison based on a detected fingerprint indicated by the detection signal (i.e., the fingerprint 81) and the reference fingerprint indicated by the reference data. The processing unit 4 is further configured to generate, when it is determined that the detected fingerprint matches the reference fingerprint in the fingerprint comparison, an affirmative notification indicating that the user to which the fingerprint 81 belongs is identified as the holder of the smart card, and to generate, when it is determined that the detected fingerprint does not match the reference fingerprint in the fingerprint comparison, a negative notification indicating that the user to which the fingerprint 81 belongs is not the holder of the smart card. It should be noted that implementation of fingerprint comparison is not limited to what is disclosed herein and may vary in other embodiments. The fingerprint comparison performed by the processing unit 4 is well known in the art, and details thereof are omitted herein for the sake of brevity.

In one embodiment, the reference data that indicates a reference fingerprint of a holder of the smart card is stored in a database running on a computer or a cloud computing platform that is coupled to the card reading module 82.

The processing unit 4 may be implemented by a processor, a central processing unit (CPU), a microprocessor, a micro control unit (MCU), a system on a chip (SoC), or any circuit configurable/programmable in a software manner and/or hardware manner to implement functionalities discussed in this disclosure.

The cover layer 5 is in a form of a film. The cover layer 5 is disposed in the cavity 13 of the card body 1 and is coated over the sensing surface 31 of the fingerprint sensor 3. The cover layer 5 has an upper surface 51 that is coplanar with the front surface 11 of the card body 1, and a bottom surface 52 that is opposite to the upper surface 51 and that contacts the sensing surface 31 of the fingerprint sensor 3.

The cover layer 5 is made of a solid solution, or a high-k dielectric material such as a high-k colloidal polymer that can be hardened or toughened by employing a curing chemical process. In one embodiment, the cover layer 5 is fabricated by pasting a specific adhesive sheet on the sensing surface 31 of the fingerprint sensor 3. In one embodiment, the cover layer 5 is fabricated by filling a predetermined liquid (e.g., emulsion or liquid crystal) on the sensing surface 31 of the fingerprint sensor 3 and then solidifying the predetermined liquid. A thickness (D) of the cover layer 5 between the upper surface 51 and the bottom surface 52 ranges from 25 micrometers to 80 micrometers. The cover layer 5 has a dielectric constant ranging from one to eight.

Covered by the cover layer 5, the fingerprint sensor 3 may be prevented from being stained with dust. Therefore, the fingerprint sensor 3 is capable of accurately detecting charges on most portions of the fingerprint 81, and accordingly sensitivity of fingerprint detection and accuracy of fingerprint identification of the smart card may be maintained.

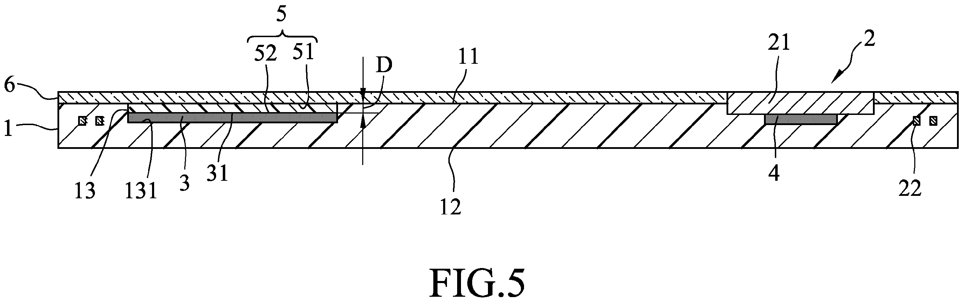

Referring to Figure 5, a second embodiment of the smart card according to the disclosure is illustrated. Since the second embodiment is similar to the first embodiment, only differences between the first and second embodiments are explained in the following paragraphs for the sake of brevity.

The smart card further includes a protective layer 6. The protective layer 6 is implemented by a transparent film, and may be made of a high-k dielectric material such as a high-k polymer (e.g., polyimide), aluminium oxide (Al₂O₃) or silicon dioxide (SiO₂). The protective layer 6 is coated over the front surface 11 of the card body 1 and the cover layer 5. The convertor circuit 21 of the transmission unit 2 is exposed from and coplanar with the protective layer 6.

It should be noted that the protective layer 6 covers the upper surface 51 of the cover layer 5 such that the cover layer 5 is sealed between the protective layer 6 and the card body 1. Because no air gap exists between the protective layer 6 and the cover layer 5 or between the cover layer 5 and the fingerprint sensor 3, the ability of the fingerprint sensor 3 to detect charges on the fingerprint 81 is kept equal and uniform for various parts of the fingerprint 81 when the user places his/her finger on the protective layer 6. Therefore, sensitivity of fingerprint detection and accuracy of fingerprint identification of the smart card may be enhanced. It is worth to note that the protective layer 6 does not have to be opened for exposing the fingerprint sensor 3, so fabricating the protective layer 6 may be simple.

To sum up, the smart card according to the disclosure utilizes the cover layer 5 to cover the fingerprint sensor 3 so as to prevent the fingerprint sensor 3 from being stained with dust. Therefore, sensitivity of fingerprint detection and accuracy of fingerprint identification of the smart card may be unaffected by dust accumulation. Moreover, when the fingerprint sensor 3 is further covered by the protective layer 6 on the upper surface 51 of the cover layer 5, the thickness (D) of the cover layer 5 and the dielectric constant of the cover layer 5 may be designed to maintain the sensitivity of fingerprint detection and the accuracy of fingerprint identification of the smart card.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A smart card for recognizing a fingerprint (81) of a user, said smart card **characterized by**:
a card body (1) having a front surface (11) and a back surface (12) that are opposite to each other, and being formed with a cavity (13) in said front surface (11);
a transmission unit (2) disposed on said card body (1), and configured to be coupled to a card reading module (82), and to output electricity based on an electrical signal generated by the card reading module (82);
a fingerprint sensor (3) electrically connected to said transmission unit (2) for receiving the electricity therefrom, having a sensing surface (31) for detecting the fingerprint (81), and being accommodated in said cavity (13) of said card body (1) with said sensing surface (31) opposite to and facing away from said back surface (12) of said card body (1) and receding with respect to said front surface (11), fingerprint sensor (3) being configured to be activated in response to receipt of the electricity from said transmission unit (2), and after being activated, to generate a detection signal based on the fingerprint (81) upon detecting the fingerprint (81);
a processing unit (4) disposed in said card body (1), electrically connected to said transmission unit (2) and said fingerprint sensor (3) respectively for receiving the electricity and the detection signal therefrom, and configured to be activated in response to receipt of the electricity from said transmission unit (2) and after being activated, to perform signal processing on the detection signal upon receiving the detection signal; and
a cover layer (5) disposed in said cavity (13) of said card body (1) and covering said sensing surface (31) of said fingerprint sensor (3).

2. The smart card as claimed in claim 1, **characterized in that** said cover layer (5) has a dielectric constant ranging from one to eight.

3. The smart card as claimed in claim 2, **characterized in that** said cover layer (5) is made of colloid.

4. The smart card as claimed in any one of claims 1 to 3, **characterized in that** said cover layer (5) has an upper surface (51) that is coplanar with said front surface (11) of said card body (1).

5. The smart card as claimed in claim 4, **characterized in that** said cover layer (5) further has a bottom surface (52) that is opposite to said upper surface (51), and a thickness of said cover layer (5) between said upper surface (51) and said bottom surface (52) ranges from 25 micrometers to 80 micrometers.

6. The smart card as claimed in claim 4, further **characterized by** a protective layer (6) that is coated over said front surface (11) of said card body (1) and said cover layer (5).

7. The smart card as claimed in any one of claims 1 to 6, **characterized in that** said fingerprint sensor (3) includes a contact pad, and a controller that is implemented by an unpackaged chip.

8. The smart card as claimed in any one of claims 1 to 7, the card reading module (82) including a contactless card reader (821), **characterized in that** said transmission unit (2) includes:
an induction coil (22) that is embedded in said card body (1), and that is configured to be inductively coupled to the contactless card reader (821) so as to induce generation of the electrical signal by the contactless card reader (821) to thereby produce a voltage through electromagnetic induction; and
a rectifier circuit (23) that is electrically connected between said induction coil (22) and said fingerprint sensor (3), and that is configured to generate the electricity based on the voltage produced by said induction coil (22).

9. The smart card as claimed in any one of claims 1 to 8, the card reading module (82) including a contact card reader (822), **characterized in that** said transmission unit (2) includes:
a convertor circuit (21) that is electrically connected to said fingerprint sensor (3), that is disposed on and exposed from said front surface (11) of said card body (1), and that is configured to be physically and electrically connected to the contact card reader (822) for receiving the electrical signal from the contact card reader (822) and to convert the electrical signal into the electricity.
